# EUROPÄISCHE PATENTSCHRIFT

(11) **EP 2 896 064 B1**
(45) Veröffentlichungstag und Bekanntmachung des Hinweises auf die Patenterteilung: **26.02.2020**
(21) Anmeldenummer: 13785810.6
(22) Anmeldetag: 13.09.2013
(51) Int. Cl.: H01J 37/34, C23C 14/35

(54) **ROHRFÖRMIGES TARGET**
TUBULAR TARGET
CIBLE TUBULAIRE

(30) Priorität: 17.09.2012 AT 3652012 U
(43) Veröffentlichungstag der Anmeldung: 22.07.2015
(73) Patentinhaber: Plansee SE, 6600 Reutte (AT)
(72) Erfinder: MUTSCHLECHNER, Walter, A-6600 Reutte (AT); DRONHOFER, André, A-6600 Reutte (AT); LINKE, Christian, A-6600 Ehenbichl (AT)
(86) Internationale Anmeldenummer: PCT/AT2013/000152
(87) Internationale Veröffentlichungsnummer: WO 2014/040100

(56) Entgegenhaltungen:
- EP-B1- 1 225 249
- DE-A1-102006 017 455
- US-A1- 2004 159 539
- US-A1- 2009 208 280

## Beschreibung

Die Erfindung betrifft ein Target für eine Kathodenzerstäubungsanlage mit einem rohrförmigen Targetkörper.

EP 1 225 249 B1 offenbart ein rohrförmiges Target für Kathodenzerstäubungsanlagen. Gemäß einer Ausgestaltung ist an den Enden eines rohrförmigen Targetkörpers aus einem Zerstäubungsmaterial jeweils ein Trägerrohr bzw. ein Anschlussrohr angeordnet. Mittels der Trägerrohre, die aus dem Targetkörper herausragen, wird das Target in eine Anlage eingebaut. In einer Ausgestaltung wird ein Trägerrohr in ein offenes Ende des Targetkörpers eingesteckt und anschließend mittels einer Schraube gesichert, die durch einen Flansch des Trägerrohrs in eine Stirnkante des Targetkörpers geschraubt wird. Alternativ ist am Targetkörper ein Außengewinde für eine Überwurfmutter vorgesehen, mittels der ein Flansch des Trägerrohrs an das Stirnende des Targetkörpers gepresst werden kann.

Es ist Aufgabe der Erfindung ein einfach und sicher montierbares rohrförmiges Target bereitzustellen.

Diese Aufgabe wird mit den Merkmalen des Anspruchs 1 gelöst.

Vorteilhafte Ausgestaltungen sind Gegenstand der Unteransprüche.

Gemäß Anspruch 1 ist ein Target für eine Kathodenzerstäubungsanlage mit einem rohrförmigen Targetkörper aus einem Zerstäubungsmaterial und zwei am Targetkörper befestigbaren Anschlussstücken vorgesehen. Mittels der Anschlussstücke kann der Targetkörper an einer Kathodenzerstäubungsanlage bzw. Sputteranlage angeschlossen bzw. befestigt werden. Ein erstes Anschlussstück ist mit einem ersten Ende des Targetkörpers und ein zweites Anschlussstück ist mit einem zweiten Ende des Targetkörpers verbindbar. Ein Anschlussstück kann aus einem oder aus mehreren Teilen hergestellt sein bzw. bestehen, so dass ein sicherer vakuumdichter Anschluss des Targetkörpers an eine Kathodenzerstäubungsanlage gewährleitet ist.

Jedes Anschlussstück weist zumindest ein Arretierungsmittel auf, um das jeweilige Anschlussstück verdrehsicher am Targetkörper zu befestigen bzw. zu arretieren. D.h. nach dem Verbinden des jeweiligen Anschlussstücks mit dem Targetkörper wird mittels des zumindest einen Arretierungsmittels ein Verdrehen des jeweiligen Anschlussstücks um eine Längsachse des rohrförmigen Targetkörpers blockiert bzw. gesperrt. In anderen Worten bietet das zumindest eine Arretierungsmittel eine Verdrehsicherung für das jeweilige Anschlussstück relativ zum Targetkörper. Ein Arretierungsmittel kann an einem Anschlussstück beispielsweise als vorspringende Nase bzw. als Rastelement ausgebildet sein, die bzw. das in entsprechende Aussparungen am Targetkörper eingreift oder -rastet, wenn das Anschlussstück seine End- bzw. Arbeitsposition am Targetkörper einnimmt. In anderen Worten ist an jedem Anschlussstück zumindest ein Arretierungsmittel ausgebildet, das bei der Verwendung - d.h. bei Rotation des Targets in einer Anlage - gewährleistet, dass das auf die Anschlussstücke übertragene Drehmoment sicher auf den Targetkörper übertragen wird. Eine Verdrehung oder Verrutschen der Anschlusstücke relativ zum Targetkörper um die Längsachse des rohrförmigen Targetkörpers wird verhindert. Bei der EP 1 225 249 B1 wird ein Anschlussrohr mittels einer Schraube, durch einen Flansch oder mittels einer Überwurfmutter am Targetkörper gesichert. Im Gegensatz dazu bietet die Erfindung ein Target, bei dem das Arretierungsmittel am jeweiligen Anschlussstück einteilig mit dem Anschlussstück ausgebildet ist. D.h. die Erfindung stellt ein Target bereit, das weniger Komponenten aufweist, wodurch eine einfachere und damit zeitsparende Montage des Targets möglich wird ohne dabei die sichere Verbindung zwischen Targetkörper und Anschlussstücken zu beeinträchtigen.

Bevorzugt ist das zumindest eine Arretierungsmittel am jeweiligen Anschlussstück ausgebildet, in zumindest eine Ausnehmung am Umfang des Targetkörpers einzugreifen. Beispielsweise ist das zumindest eine Arretierungsmittel als ein oder mehrere Vorsprünge oder als eine oder mehrere (Rast-)Nasen am jeweiligen Anschlussstück ausgebildet. Besonders bevorzugt ist das zumindest eine Arretierungsmittel als Flansch mit zumindest einer Ausnehmung, Unterbrechung bzw. Lücke ausgebildet, so dass der Flansch beim Einsetzen oder Einschieben des jeweiligen Anschlussstücks in eine entsprechende Ausnehmung am Targetkörper eingreift. Beispielsweise weist eine Stirnkante des Targetkörpers eine Erhebung auf, die in die entsprechende Ausnehmung am Flansch eingreift. Z.B. sind mindestens 2, 3, 4 oder 8 Ausnehmungen am Flansch vorgesehen, um eine verdrehsichere Arretierung herzustellen.

Gemäß einer Ausgestaltung ist das zumindest eine Arretierungsmittel als Rastelement ausgebildet, das dazu ausgelegt ist in eine entsprechende Rastaufnahme am Targetkörper einzurasten. Beispielsweise ist das Arretierungsmittel als Federstift bzw. als mit einer Feder vorgespannte Rastnase ausgebildet, der bzw. die in eine entsprechende Ausnahme oder Vertiefung des Targetkörpers einrastet wenn das Anschlussstück in den Targetkörper eingesteckt wird und seine Endposition erreicht.

Bevorzugt sind die Anschlussstücke wiederlösbar mit dem Targetkörper verbindbar. D.h. die Anschlussstücke können nach dem Ende einer Nutzungsdauer des Targets wieder aus dem Targetkörper gelöst werden, um z.B. in einen neuen Targetkörper eingesetzt zu werden. Beispielsweise ist ein Bajonettverschluss zwischen Anschlussstück und Targetkörper vorgesehen. D.h. das zumindest eine Arretierungsmittel ist als ein Bajonettverschlusselement ausgebildet. Z.B. sind an einem Anschlussstück entsprechende Vorsprünge bzw. Nasen ausgebildet und am Targetkörper entsprechender Längs- und Quernuten in die die Nasen eingreifen. Alternativ sind am Anschlussstück Längs- und Quernuten bzw. Längs- und Querschlitze vorgesehen in die entsprechende am Targetkörper ausgebildete Vorsprünge oder Nasen eingreifen. Auf diese Weise werden die Anschlussstücke einfach und sicher wiederlösbar mit dem Targetkörper verbunden.

Vorzugsweise ist für zumindest ein Anschlussstück zumindest ein Sicherungselement mit einer Verbindungsachse senkrecht zur rohrförmigen Targetkörperachse vorgesehen. Beispielsweise ist zumindest eine Schraube, ein Niet oder ein Splint vorgesehen, die bzw. der senkrecht zur Targetkörperachse durch das Anschlussstück und den Targetkörper geführt ist und das Anschlussstück mit dem Targetkörper verdrehsicher verbindet.

Gemäß einer Ausgestaltung ist zumindest ein Anschlussstück stoffschlüssig mit dem Targetkörper verbunden. Beispielsweise ist ein Anschlussstück mit dem Targetkörper verklebt oder verlötet, so dass eine elektrisch leitende Verbindung zwischen den Komponenten hergestellt wird. Insbesondere wird durch Löten bzw. Kleben die Verbindung zwischen den Komponenten noch stabiler. Nach einem Ende der Nutzungsdauer des Targets kann zur Wiederverwendung der Anschlusstücke die Verbindung zwischen den Komponenten gelöst werden. Beispielsweise wird durch Erhitzen des Targets ein Kleber zersetzt oder ein Lot verflüssigt, um die Verbindung zu lösen und die Anschlussstücke vom Targetkörper zu trennen.

Gemäß einer bevorzugten Ausgestaltung ist ein Target für eine Kathodenzerstäubungsanlage vorgesehen, das einen rohrförmigen Targetkörper aus einem Zerstäubungsmaterial, und zwei Anschlussstücke zum Anschließen des Targetkörpers an eine Kathodenzerstäubungsanlage aufweist. Ein erstes Anschlussstück ist mit einem ersten Ende des Targetkörpers und ein zweites Anschlussstück mit einem zweiten Ende des Targetkörpers verschraubbar. Beispielsweise weisen die Anschlussstücke ein Außengewinde auf und der Targetkörper ein entsprechendes Innengewinde oder die Anschlussstücke weisen ein Innengewinde auf und der Targetkörper ein entsprechendes Außengewinde. Zusätzlich sind die zwei Anschlussstücke stoffschlüssig mit dem Targetkörper verbunden. Beispielsweise miteinander verklebt, verlötet oder verschweißt. D.h. die Verschraubung wird zusätzlich durch den Stoffschluss gesichert, wobei die Verbindung wie oben beschrieben durch Erhitzen wieder gelöst werden kann, um die Anschlussstücke zur Wiederverwendung aus dem Targetkörper herauszuschrauben.

Gemäß einer Ausgestaltung weist zumindest ein Anschlussstück an seinem Außenumfang zumindest eine Vertiefung auf in die zum Verbinden des Anschlussstücks mit dem Targetkörper Lotmaterial einbringbar ist. Beispielsweise ist zumindest eine umlaufende Nut am Anschlussstück vorgesehen in die vor dem Zusammenstecken oder -schrauben Lotplättchen oder ein Lotring eingelegt werden, anschließend wird das Anschlussstück in den Targetkörper eingesteckt und das Target erwärmt, so dass das Lot schmilzt und der Targetkörper mit dem Anschlussstück verbunden wird. Auf diese Weise können die Komponenten des Targets einfach, schnell und sicher miteinander verbunden werden.

Vorzugsweise ist zwischen den Anschlussstücken und dem Targetkörper ein elektrisch leitendes Material angeordnet, um eine sichere elektrische Verbindung der Komponenten zu gewährleisten, beispielsweise eine Graphitfolie oder ein Kupfernetz oder wie oben beschrieben ein elektrisch leitender Kleber bzw. Lotmaterial.

Gemäß einer Ausgestaltung weist zumindest ein Anschlussstück eine kegelförmige Außenfläche auf, die dazu ausgebildet ist in eine entsprechende kegelförmige Öffnung an einem Ende des Targetkörpers einzugreifen. D.h. zwischen Anschlussstück und Targetkörper wird eine Kegelverbindung hergestellt, die zusätzlich durch wie oben beschriebene Arretierungsmittel gegen Verdrehen gesichert sein kann.

Vorzugsweise erstrecken sich die mit dem Targetkörper verbundenen Anschlussstücke nicht über die gesamte Länge des rohrförmigen Targetkörpers. D.h. die Anschlussstücke sind in die jeweiligen Enden des Targetkörpers einsteckbar, so dass am nach außen weisenden Ende der Anschlussstücke beispielsweise weitere Anschlusselemente wie z.B. Vorsprünge oder Flansche zum Anschließen an eine Kathodenzerstäubungsanlage ausgebildet sein können.

Anhand der Figuren werden Ausführungsformen der Erfindung näher erläutert.

Es zeigen:
- Fig. 1: eine axiale Draufsicht auf ein rohrförmiges Target gemäß einer ersten Ausgestaltung,
- Fig. 2: eine seitliche Schnittansicht des Targets von Fig. 1, und
- Fig. 3: ein axiale Draufsicht auf ein rohrförmiges Target gemäß einer zweiten Ausgestaltung.

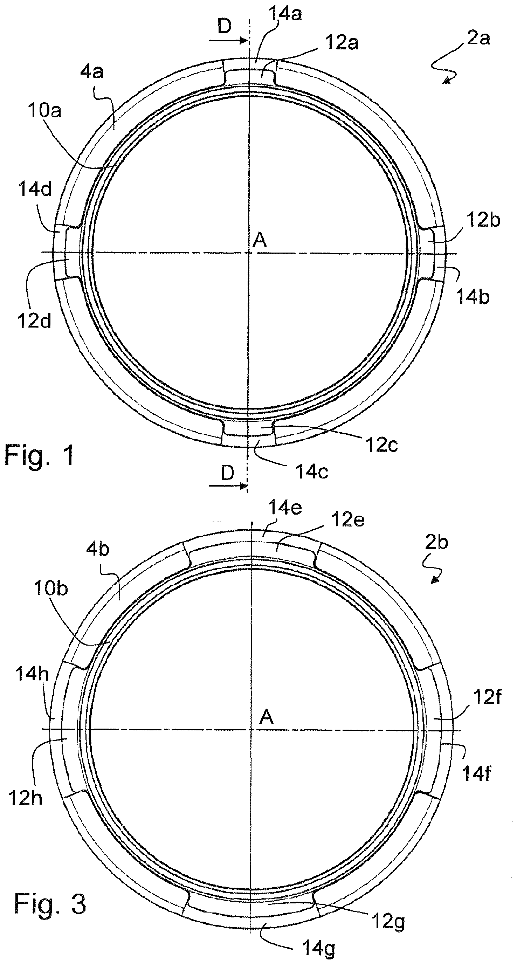

Fig. 1 zeigt eine Draufsicht in Richtung der Längsachse A eines rohrförmigen Targets 2a gemäß einer ersten Ausgestaltung. Das Target 2a ist zur Verwendung in Kathodenzerstäubungsanlagen ausgelegt und weist einen rohrförmigen Targetkörper 4a aus einem Zerstäubungsmaterial auf. Beide Enden des Targets 2a sind gleich bzw. identisch ausgestaltet, so dass der Übersichtlichkeit halber in den Figuren nur ein Ende des Targets 2a bzw. des Targetkörpers 4a dargestellt ist. An den offenen Enden des Targetkörpers 4a ist jeweils ein rohrförmiges Anschlussstück 10a eingesteckt. Mittels der Anschlussstücke 10a kann das Target 2a an eine Kathodenzerstäubungsanlage angeschlossen werden. Bei Verwendung wird das Target 2a in eine Vakuumkammer einer Anlage eingebaut, wobei im Innenvolumen des hohlen Targets 2a beispielsweise Kühleinrichtungen und eine Magnetvorrichtung angeordnet sind. Mittels der Anschlussstücke 10a wird eine gasdichte Verbindung des Targets 2a zur Anlage gewährleistet.

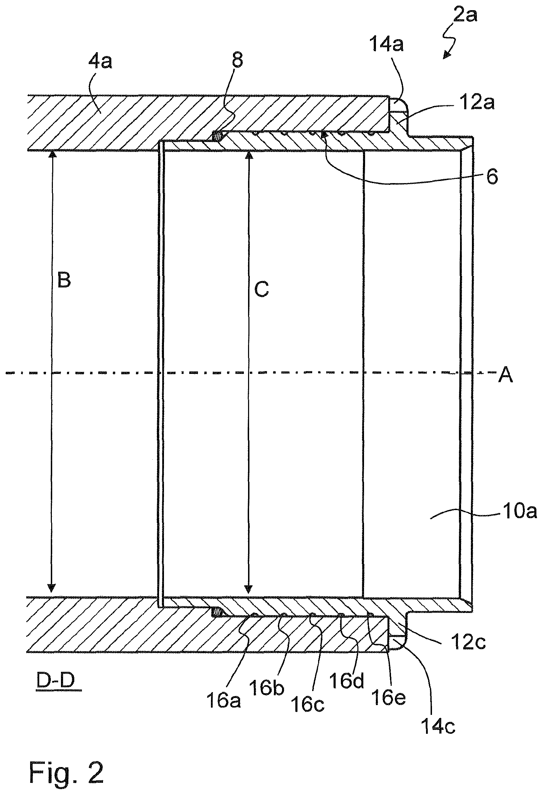

Der Targetkörper 4a umgibt die Anschlussstücke 10a konzentrisch, wobei die Anschlussstücke 10a aus dem Targetkörper 4a herausragen (Fig. 2), um das Target 2a an eine Anlage anzuschließen. Die Anschlussstücke 10a werden jeweils in ein Ende des Targetkörpers 4a eingeschoben, so dass an den außen- bzw. freiliegenden Enden der Anschlussstücke 10a beispielsweise ein Flansch oder andere vorspringende Elemente zum Befestigen an einer Anlage ausgebildet sein können.

Fig. 2 zeigt eine seitliche Schnittansicht eines Endes des rohrförmigen Targets 2a von Fig. 1 entlang der Linie D-D. Das dargestellte Anschlussstück 10a entspricht dem am anderen Ende des Targets 2a angeordneten zweiten Anschlussstück (nicht dargestellt). Das Anschlussstück 10a weist Flanschelemente 12a-d bzw. Vorsprünge in radialer Richtung auf, die dazu ausgelegt sind in entsprechende Aussparungen 14a-d bzw. Vertiefungen an der Stirnseite des Targetkörpers 4a einzugreifen. Die Flanschelemente 12a-d und Aussparungen 14a-d sichern das eingeschobene Anschlussstück 10a vor einem Verdrehen bezüglich des Targetkörpers 4a. In anderen Worten arretieren die Flanschelemente 12a-d das Anschlussstück 10a verdrehsicher am Targetkörper 4a.

Am Umfang des Anschlussstücks 10a, der in den Targetkörper 4a eingeschoben wird, sind mehrere umlaufende Nuten 16a-e vorgesehen. In die Nuten 16a-e wird vor dem Einschieben in den Targetkörper 4a Lotmaterial eingebracht, z.B. in Form von Lötdraht oder Lötplättchen. Nach dem Einschieben wird das Target 2a bzw. der Endbereich des Targets 2a erwärmt, so dass das eingebrachte Lotmaterial schmilzt und eine gasdichte elektrisch leitende Verbindung zwischen Anschlussstück 10a und Targetkörper 4a herstellt wird.

Der Targetkörper 4a weist eine Aufnahmeöffnung auf, in die das Anschlussstück 10a eingeschoben wird. Ein innenliegender Falz 6 am Targetkörper dient als Tiefenanschlag für das eingeschobene Anschlussstück 10a. Der Innendurchmesser A des Targetkörpers 4a und der Innendurchmesser C des Anschlussstücks 10a sind gleich oder im Wesentlichen gleich, so dass ein ebener Übergang ohne Stufe zwischen den beiden Komponenten bereitgestellt wird. Im Falz 6 ist ein Dichtring 8 angeordnet, der zusätzlich zum oben beschriebenen Löten eine gasdichte Verbindung zwischen Anschlussstück 10a und Targetkörper 4a gewährleistet. Alternativ ist kein Dichtring 8 vorgesehen.

Fig. 3 zeigt eine Draufsicht auf ein Target 2b gemäß einer zweiten Ausgestaltung. Soweit nicht anders angegeben entsprechen die Elemente und Funktionen des Targets 2b den oben in Bezug auf die erste Ausgestaltung des Targets 2a beschriebenen Elementen und Funktionen. Im Unterschied zur ersten Ausgestaltung sind breitere Flanschelemente 12e-h am Anschlussstück 10b und entsprechende breitere Aussparungen 14e-h am Targetkörper 4b vorgesehen. Breitere Flanschelemente 12e-h sind beispielsweise robuster gegenüber Scherbelastungen beim Betrieb bzw. Rotation des Targets 2b in einer Kathodenzerstäubungsanlage. Alternativ kann beispielsweise nur ein Flanschelement vorgesehen sein oder eine Vielzahl von Flanschelementen, um eine verdrehsichere Verbindung zwischen Anschlussstück und Targetkörper herzustellen.

### Bezugszeichenliste

- 2a-b: rohrförmiges Target
- 4a-b: Targetkörper
- 6: Falz
- 8: Dichtring
- 10a-b: Anschlussstück
- 12a-h: Flanschelement
- 14a-h: Aussparung
- 16a-e: umlaufende Nut

- A: Target-Achse
- B: Innendurchmesser Targetkörper
- C: Innendurchmesser Anschlussstück

## Patentansprüche

1. Target (2a, 2b) für eine Kathodenzerstäubungsanlage mit
einem rohrförmigen Targetkörper (4a, 4b) aus einem Zerstäubungsmaterial, und
zwei mit dem Targetkörper (4a, 4b) verbindbaren Anschlussstücken (10a, 10b) zum Anschließen des Targetkörpers (4a, 4b) an eine Kathodenzerstäubungsanlage,
wobei ein erstes Anschlussstück mit einem ersten Ende des Targetkörpers (4a, 4b) und ein zweites Anschlussstück mit einem zweiten Ende des Targetkörpers (4a, 4b) verbindbar ist, wobei zumindest ein Arretierungsmittel (12a-h) an jedem Anschlussstück (10a, 10b) ausgebildet ist, um das jeweilige Anschlussstück (10a, 10b) verdrehsicher mit dem Targetkörper (4a, 4b zu verbinden, **dadurch gekennzeichnet dass** das zumindest eine Arretierungsmittel (12a-h) einteilig mit dem jeweiligen Anschlussstück (10a, 10b) ausgebildet ist.

2. Target gemäß Anspruch 1, wobei das zumindest eine Arretierungsmittel (12a-h) dazu ausgebildet ist in zumindest eine Ausnehmung (14a-h) des Targetkörpers (4a, 4b) einzugreifen.

3. Target gemäß Anspruch 1 oder 2, wobei das zumindest eine Arretierungsmittel (12a-h) als Flansch mit zumindest einer Ausnehmung ausgebildet ist.

4. get gemäß Anspruch 1 oder 2, wobei das zumindest eine Arretierungsmittel ein Rastelement aufweist, das dazu ausgelegt ist in eine entsprechende Rastaufnahme am Targetkörper (4a, 4b) einzurasten.

5. Target gemäß Anspruch 1 oder 2, wobei das zumindest eine Arretierungsmittel als Bajonettverschlusselement ausgebildet ist.

6. Target gemäß einem der vorhergehenden Ansprüchen, wobei für zumindest ein Anschlussstück zumindest ein Sicherungselement mit einer Verbindungsachse senkrecht zur Targetkörperachse (A) vorgesehen ist, insbesondere zumindest eine Schraube, ein Niet oder ein Splint.

7. Target gemäß einem der vorhergehenden Ansprüchen, wobei zumindest ein Anschlussstück (10a, 10b) stoffschlüssig mit dem Targetkörper (4a, 4b) verbunden ist, insbesondere mit dem Targetkörper verklebt oder verlötet ist.

8. Target gemäß einem der vorhergehenden Ansprüchen, wobei zumindest ein Anschlussstück (10a, 10b) an seinem Außenumfang zumindest eine Vertiefung (16a-e) aufweist, insbesondere zumindest eine umlaufende Nut aufweist, in die zum Verbinden des Anschlussstücks (10a, 10b) mit dem Targetkörper (4a, 4b) Lotmaterial einbringbar ist.

9. Target gemäß einem der vorhergehenden Ansprüchen, wobei zwischen den Anschlussstücken (10a, 10b) und dem Targetkörper (4a, 4b) ein elektrisch leitendes Material angeordnet ist, insbesondere elektrisch leitender Kleber, Lot, Graphitfolie oder ein Kupfernetz.

10. Target gemäß einem der vorhergehenden Ansprüchen, wobei zumindest ein Anschlussstück eine kegelförmige Außenfläche aufweist, die dazu ausgebildet ist in eine entsprechende kegelförmige Öffnung an einem Ende des Targetkörpers einzugreifen.

## Claims

1. A target (2a, 2b) for a cathode atomization system, having a tubular target body (4a, 4b) made of an atomization material, and
two connection pieces (10a, 10b), connectable to the target body (4a, 4b), for connecting the target body (4a, 4b) to a cathode atomization system, wherein a first connection piece is connectable to a first end of the target body (4a, 4b) and a second connection piece is connectable to a second end of the target body (4a, 4b), wherein at least one locking means (12a-h) is formed on each connection piece (10a, 10b), in order to connect the respective connection piece (10a, 10b) to the target body (4a, 4b) in a manner secured against rotation, wherein the at least one locking means (12a-h) is formed in one piece with the respective connection piece (10a, 10b).

2. The target as claimed in claim 1, wherein the at least one locking means (12a-h) is designed to engage into at least one recess (14a-h) of the target body (4a, 4b).

3. The target as claimed in claim 1 or 2, wherein the at least one locking means (12ah) is formed as a flange with at least one recess.

4. The target as claimed in claim 1 or 2, wherein the at least one locking means has a latching element, which is designed to latch into a corresponding latching receptacle on the target body (4a, 4b).

5. The target as claimed in claim 1 or 2, wherein the at least one locking means is formed as a bayonet closure element.

6. The target as claimed in one of the preceding claims, wherein at least one securing element with a connecting axis perpendicular to the target body axis (A) is provided for at least one connection piece, in particular at least one screw, a rivet or a split pin.

7. The target as claimed in one of the preceding claims, wherein at least one connection piece (10a, 10b) is integrally connected to the target body (4a, 4b), in particular is adhesively bonded or soldered to the target body.

8. The target as claimed in one of the preceding claims, wherein at least one connection piece (10a, 10b) has at least one depression (16a-e) on its outer circumference, in particular has at least one circumferential groove into which solder material can be introduced for connecting the connection piece (10a, 10b) to the target body (4a, 4b).

9. The target as claimed in one of the preceding claims, wherein an electrically conductive material, in particular electrically conductive adhesive, solder, graphite foil or a copper mesh, is arranged between the connection pieces (10a, 10b) and the target body (4a, 4b).

10. The target as claimed in one of the preceding claims, wherein at least one connection piece has a conical outer face, which is designed to engage into a corresponding conical opening at one end of the target body.

## Revendications

1. Cible (2a, 2b) pour une installation de pulvérisation cathodique comprenant un corps de cible tubulaire (4a, 4b) en un matériau de pulvérisation, et
deux pièces de raccordement (10a, 10b) pouvant être raccordées au corps de cible (4a, 4b) pour le raccordement du corps de cible (4a, 4b) à une installation de pulvérisation cathodique,
une première pièce de raccordement pouvant être connectée à une première extrémité du corps de cible (4a, 4b) et une deuxième pièce de raccordement pouvant être connectée à une deuxième extrémité du corps de cible (4a, 4b),
au moins un moyen de blocage (12a-h) étant réalisé au niveau de chaque pièce de raccordement (10a, 10b), afin de connecter la pièce de raccordement respective (10a, 10b) de manière solidaire en rotation au corps de cible (4a, 4b),
**caractérisée en ce que** l'au moins un moyen de blocage (12a-h) est réalisé d'une seule pièce avec la pièce de raccordement respective (10a, 10b).

2. Cible selon la revendication 1,
dans laquelle l'au moins un moyen de blocage (12ah) est réalisé de manière à venir en prise dans au moins un évidement (14a-h) du corps de cible (4a, 4b) .

3. Cible selon la revendication 1 ou 2, dans laquelle l'au moins un moyen de blocage (12a-h) est réalisé sous forme de bride avec au moins un évidement.

4. Cible selon la revendication 1 ou 2, dans laquelle l'au moins un moyen de blocage présente un élément d'encliquetage qui est conçu pour s'encliqueter dans un logement d'encliquetage correspondant sur le corps de cible (4a, 4b).

5. Cible selon la revendication 1 ou 2, dans laquelle l'au moins un moyen de blocage est réalisé sous forme d'élément de fermeture à baïonnette.

6. Cible selon l'une quelconque des revendications précédentes, dans laquelle, pour au moins une pièce de raccordement, il est prévu au moins un élément de fixation pourvu d'un axe de connexion perpendiculairement à l'axe du corps de cible (A), en particulier au moins une vis, un rivet ou une goupille.

7. Cible selon l'une quelconque des revendications précédentes, dans laquelle au moins une pièce de raccordement (10a, 10b) est connectée par liaison de matière au corps de cible (4a, 4b), en particulier est collée ou brasée au corps de cible.

8. Cible selon l'une quelconque des revendications précédentes, dans laquelle au moins une pièce de raccordement (10a, 10b) présente au niveau de sa périphérie extérieure au moins un renfoncement (16a-e), en particulier au moins une rainure périphérique dans laquelle peut être introduite de la matière de brasage pour la connexion de la pièce de raccordement (10a, 10b) au corps de cible (4a, 4b).

9. Cible selon l'une quelconque des revendications précédentes, dans laquelle entre les pièces de raccordement (10a, 10b) et le corps de cible (4a, 4b) est disposé un matériau électriquement conducteur, en particulier une colle, une matière de brasage, un film de graphite ou un réseau de cuivre électriquement conducteur.

10. Cible selon l'une quelconque des revendications précédentes, dans laquelle au moins une pièce de raccordement présente une surface extérieure de forme conique qui est réalisée pour venir en prise dans une ouverture de forme conique correspondante à une extrémité du corps de cible.
